# FASCICULE DE BREVET EUROPEEN

(11) **EP 3 678 168 B1**
(45) Date de publication et mention de la délivrance du brevet: **31.08.2022**
(21) Numéro de dépôt: 19220269.5
(22) Date de dépôt: 31.12.2019
(51) Int. Cl.: H01L 21/762, H01L 21/268, H01L 21/322

(54) **PROCÉDÉ DE GUÉRISON AVANT TRANSFERT D'UNE COUCHE SEMI-CONDUCTRICE**
AUSHEILVERFAHREN VOR DEM TRANSFER EINER HALBLEITERSCHICHT
CURING METHOD BEFORE TRANSFER OF A SEMICONDUCTOR LAYER

(30) Priorité: 07.01.2019 FR 1900126
(43) Date de publication de la demande: 08.07.2020
(73) Titulaire: Commissariat à l'énergie atomique et aux énergies alternatives, 75015 Paris (FR)
(72) Inventeur: ACOSTA ALBA, Pablo, 38054 GRENOBLE CEDEX 09 (FR); MAZEN, Frédéric, 38054 GRENOBLE CEDEX 09 (FR); KERDILES, Sébastien, 38054 GRENOBLE CEDEX 09 (FR); MAITREJEAN, Sylvain, 38054 GRENOBLE CEDEX 09 (FR)
(74) Mandataire: Brevalex

(56) Documents cités:
- EP-A1- 2 551 897
- CN-C- 100 505 163
- US-A1- 2002 053 318
- US-A1- 2010 216 295
- US-A1- 2021 057 267
- C. W. White ET AL: "Laser Annealing of Ion-Implanted Semiconductors", Science, vol. 204, no. 4392, 4 May 1979 (1979-05-04), pages 461-468, XP055613733, US ISSN: 0036-8075, DOI: 10.1126/science.204.4392.461

## Description

### DOMAINE TECHNIQUE

Le domaine de l'invention est celui des procédés de transfert d'une couche semi-conductrice d'un substrat donneur vers un substrat receveur qui mettent en œuvre une fracture le long d'un plan de fragilisation formé par implantation d'espèces dans le substrat donneur. L'invention concerne plus particulièrement la guérison de défauts causés par l'implantation.

### TECHNIQUE ANTÉRIEURE

La technologie Smart Cut^{™} est une technique bien connue pour permettre le transfert de couches minces de matériaux semi-conducteurs, voir par exemple US 2010/216295 A1. Selon cette technique, des espèces ioniques telles que de l'hydrogène et/ou de l'hélium sont implantées dans un substrat donneur afin d'y former un plan de fragilisation. Le substrat donneur est par la suite mis en contact avec un substrat receveur, par exemple par collage direct. Cette technique fait ensuite appel au développement des défauts générés au niveau du plan de fragilisation. Ce développement implique un apport énergétique, généralement réalisé au moyen d'un traitement thermique de quelques centaines de degrés, 500°C typiquement, pendant quelques dizaines de minutes. Cela conduit à la formation d'une couche confinée de cavités et de microfissures au sein de laquelle va s'initier et se propager une fracture. Cette fracture sépare le substrat donneur le long du plan de fragilisation et une couche mince du substrat donneur est ainsi transférée sur le substrat receveur.

Après le transfert, des défauts sont présents dans la couche mince transférée qui a été traversée par les espèces implantées. Ces défauts peuvent notamment correspondre à des défauts dans le réseau cristallin de la couche ou à des résidus des espèces implantées. De tels défauts dégradent fortement le fonctionnement des dispositifs électroniques formés dans ou sur la couche transférée. Il est donc nécessaire de les guérir. La technique couramment utilisée pour réaliser cette guérison est un traitement thermique à haute température. Ce traitement thermique atteint généralement des températures supérieures à 900°C, typiquement 1100-1200°C et dure quelques secondes (environ 30 secondes pour un recuit thermique rapide RTA (« Rapid Thermal Annealing ») ou quelques minutes, voire quelques heures, dans un four vertical. Dans tous les cas, l'intégralité du substrat receveur sur lequel la couche mince a été transférée subit un traitement thermique bien au-delà de 500°C. Un exemple d'un tel procédé est décrit dans US 2002/053318 A1.

La mise en œuvre de cette technique de guérison n'est néanmoins pas envisageable lorsque que la couche mince est transférée sur un substrat receveur susceptible d'être endommagé par l'application d'un traitement thermique à haute température. C'est le cas par exemple des substrats en polymère utilisés notamment en électronique flexible ou encore des substrats en verre qui fondent à une température proche de 600°C. C'est également le cas en intégration 3D séquentielle où les substrats présentent déjà des composants partiellement ou totalement fabriqués et comprennent donc éventuellement des lignes de cuivre qui se dégradent à partir de 400°C-500°C, des contacts en siliciure de nickel dont la conductivité peut être détériorée au-delà de 550°C, etc.

Pour répondre au besoin de limitation de budget thermique (température / durée) appliqué au substrat receveur, une solution de guérison alternative a été proposée qui consiste, comme exposé dans le brevet US 8,993,461 B2, à irradier le substrat receveur après transfert de la couche mince par un laser. Mais cette solution nécessite une couche thermiquement isolante entre la couche transférée et le substrat receveur pour ne pas venir chauffer le substrat receveur. D'autre part, pour permettre la guérison de la couche transférée par fusion partielle puis recristallisation, il faut nécessairement conserver un germe monocristallin dans la partie inférieure de la couche. Mais ce germe est alors la partie la moins bien reconstruite alors que cette partie forme la seule partie utile dans le cas d'un substrat silicium sur isolant fin par exemple.

Une autre solution de guérison alternative consiste à générer une amorphisation partielle, le plus souvent par implantation ionique, de la couche mince transférée. Cette amorphisation est suivie d'un recuit de recristallisation dit de SPER (« Solid Phase Epitaxial Regrowth »). Étant donné que le recuit SPER nécessite un budget thermique proche de celui utilisé pour déclencher la fracture, il n'est pas possible de mettre en œuvre cette solution avant le collage du substrat donneur avec le substrat receveur. Par ailleurs, pour permettre la recristallisation pendant le recuit de SPER, il est nécessaire de laisser une partie de la couche mince transférée sans aucune amorphisation. De ce fait, la guérison des défauts proches du fond de la couche n'est pas possible. Enfin, la recristallisation SPER présente des difficultés à recristalliser les derniers nanomètres proches de la surface du fait de vitesses de recristallisation différentes selon les directions cristallines et de la présence de défauts d'empilements dans la direction cristalline (111).

### EXPOSÉ DE L'INVENTION

L'invention a pour objectif de proposer une solution de guérison des défauts liés à l'implantation qui puisse être mise en œuvre à relativement basse température et être ainsi appliquée au transfert d'une couche semi-conductrice sur un substrat receveur présentant des caractéristiques qui interdisent des traitements à haute température et qui s'affranchisse des inconvénients des solutions alternatives discutées précédemment.

A cet effet, l'invention propose un procédé de guérison de défauts générés dans une couche semi-conductrice par une implantation d'espèces réalisée dans un substrat pour y former un plan de fragilisation séparant une partie massive du substrat de la couche semi-conductrice ; La couche semi-conductrice comprend une face avant traversée par les espèces implantées. Ce procédé comporte un recuit localisé comprenant une irradiation laser d'une surface avant du substrat provoquant un échauffement de la couche semi-conductrice dont l'intensité décroit de la face avant en direction du plan de fragilisation.

Certains aspects préférés mais non limitatifs de ce procédé sont les suivants :
l'irradiation laser est une irradiation impulsionnelle dont les conditions opératoires sont choisies pour échauffer une portion avant de la couche semi-conductrice sans provoquer un bullage du plan de fragilisation ;
le substrat est en silicium, en germanium ou en silicium-germanium et l'irradiation laser présente une longueur d'onde inférieure à 400 nm ;
la durée de la ou des impulsions de l'irradiation laser est inférieure à une microseconde, de préférence comprise entre 20 et 200 nanosecondes ;
la ou les impulsions de l'irradiation laser présentent une densité surfacique d'énergie choisie pour échauffer la portion avant de la couche semi-conductrice à une température supérieure à 1000°C, de préférence supérieure à 1200°C.
l'irradiation laser comprend une ou plusieurs impulsions ayant chacune une densité d'énergie choisie pour ne pas entraîner la fusion de la surface avant ;
l'irradiation laser comprend une seule impulsion dont la densité d'énergie est choisie pour entraîner la fusion de la surface avant ;
la couche semi-conductrice est recouverte d'une couche témoin qui présente une température de fusion inférieure à la température de fusion de la couche semi-conductrice ;
le procédé comprend avant le recuit localisé une amorphisation superficielle de la couche semi-conductrice ;
le procédé comprend en outre un chauffage de l'intégralité du substrat à une température choisie pour ne pas provoquer un bullage du plan de fragilisation, par exemple à une température comprise entre 50°C et 450°C ;

L'invention porte également sur un procédé de transfert d'un substrat donneur vers un substrat receveur d'une couche semi-conductrice ayant une face avant, le substrat donneur comportant un plan de fragilisation formé par implantation d'espèces qui sépare la couche semi-conductrice d'une partie massive du substrat donneur, le procédé comprenant les étapes de :
- mise en contact du substrat donneur et du substrat receveur pour former un ensemble à fracturer ;
- fracture de l'ensemble à fracturer le long du plan de fragilisation de manière à transférer la couche semi-conductrice sur le substrat receveur ;
caractérisé en ce qu'il comprend avant la mise en contact une guérison de défauts de la couche semi-conductrice liés à l'implantation d'espèces à travers la face avant, ladite guérison comportant un recuit localisé comprenant une irradiation laser d'une surface avant du substrat donneur provoquant un échauffement de la couche semi-conductrice dont l'intensité décroit de la face avant en direction du plan de fragilisation.

Selon ce procédé de transfert, la fracture peut comprendre un traitement thermique de fragilisation appliqué à l'ensemble à fracturer qui échauffe le plan de fragilisation à une température supérieure à celle à laquelle il est échauffé par le recuit localisé.

Ce procédé de transfert peut comprendre un amincissement de la couche semi-conductrice transférée sur le substrat receveur.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux figures annexées sur lesquelles :
- la figure 1 illustre un exemple de procédé de transfert d'une couche mince semi-conductrice dans lequel est réalisée une guérison de défauts liés à l'implantation selon l'invention ;
- la figure 2 représente une épaisseur de silicium amorphisée par une implantation de silicium, en fonction de différentes conditions d'implantation.

### DESCRIPTION DÉTAILLÉE

L'invention porte sur un procédé de guérison de défauts générés dans une couche mince semi-conductrice par une implantation d'espèces réalisée dans un substrat semi-conducteur, dit substrat donneur, pour y former un plan de fragilisation séparant la couche mince d'une partie massive du substrat. L'invention trouve notamment application au transfert de la couche semi-conductrice sur un substrat receveur conformément à la technologie Smart Cut^{™}, et plus particulièrement sur un substrat receveur présentant des caractéristiques qui interdisent des traitements à haute température.

Le procédé selon l'invention comprend un recuit localisé du substrat donneur qui permet de guérir des défauts présents dans la couche semi-conductrice du fait de l'implantation. Ce recuit sélectif en profondeur provoque un échauffement de la couche semi-conductrice dont l'intensité décroit avec la profondeur d'une face avant de la couche semi-conductrice en direction du plan de fragilisation et est donc maximale au voisinage de la face avant. Cette décroissance de l'intensité de l'échauffement permet de chauffer préférentiellement la zone endommagée traversée par l'implantation ionique à très haute température ce qui permet d'y guérir les défauts liés à l'implantation. Et l'élévation en température étant confinée dans une portion avant de la couche semi-conductrice, on évite de provoquer un échauffement du plan de fragilisation qui provoquerait un bullage, c'est à dire une maturation de microcavités dans le plan de fragilisation qui, en l'absence d'un raidisseur rapporté sur le substrat donneur, conduirait à une déformation de sa surface susceptible de contrarier un collage avec le substrat receveur.

Ainsi, dans le cadre du procédé Smart Cut^{™}, ce recuit localisé ne va pas engendrer de bullage et peut donc être réalisé avant même de coller les substrats donneur et receveur, le traitement thermique de fragilisation du plan de fragilisation qui concourt au transfert de la couche semi-conductrice pouvant alors être réalisé *a posteriori.* La couche semi-conductrice est ainsi guérie avant même d'être transférée. De cette manière, le substrat receveur qui peut être sensible à la température ne subit thermiquement que le traitement thermique de fragilisation qui est réalisé à une température suffisamment faible (typiquement inférieure à 500°C) et/ou sur une durée suffisamment courte pour garantir l'intégrité du substrat receveur ou de ses composants.

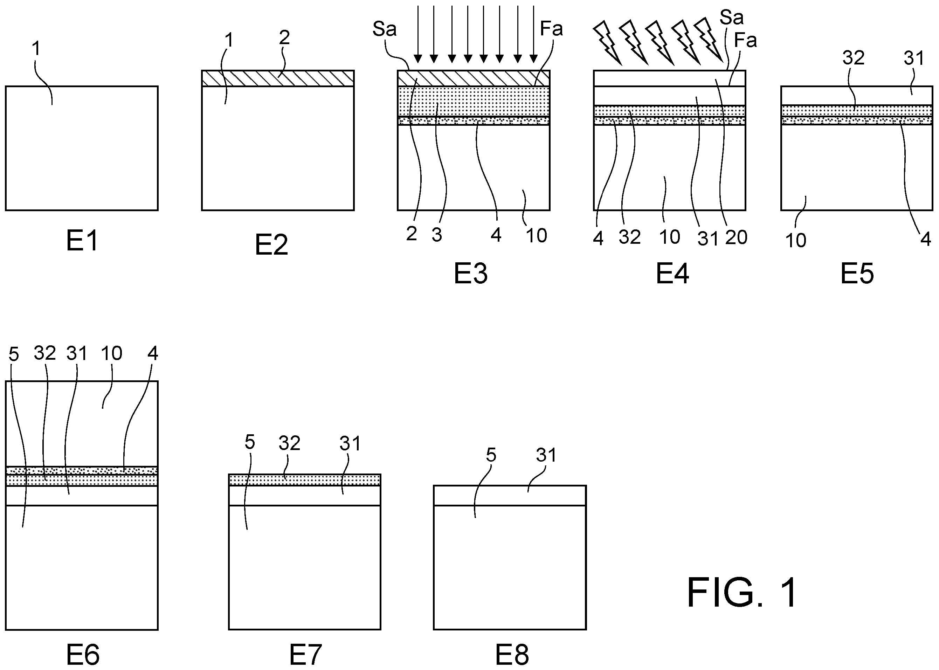

On décrit dans ce qui suit en référence à la figure 1 différentes étapes E1-E8 d'un procédé de transfert d'une couche semi-conductrice d'un substrat donneur vers un substrat receveur dans lequel le procédé de guérison selon l'invention est mis en œuvre.

Le procédé débute par une étape E1 de fourniture d'un substrat donneur 1 qui peut être un substrat de silicium, ou en tout autre matériau semi-conducteur. À titre d'exemples, il peut s'agir de silicium-germanium, de germanium ou d'un matériau III-V.

Dans une étape E2 facultative, le substrat donneur est recouvert, au moyen d'un dépôt ou d'une croissance épitaxiale, d'une couche témoin 2 dont l'utilité sera décrite par la suite.

Le procédé comprend ensuite une étape E3 de formation d'un plan de fragilisation 4 dans l'épaisseur du substrat donneur. Ce plan de fragilisation est plus particulièrement formé en soumettant une surface avant Sa du substrat donneur à une implantation d'espèces, typiquement de l'hydrogène et/ou de l'hélium. Le plan de fragilisation 4 délimite une couche semi-conductrice 3 (ici recouverte de la couche témoin 2) et une partie massive du substrat donneur 10. La couche semi-conductrice comprend une face arrière au contact du plan de fragilisation et une face avant Fa opposée à la face arrière. Les espèces traversent la couche semi-conductrice 3 depuis sa face avant lors de l'implantation et y causent des défauts qu'il convient de guérir. Ce plan de fragilisation se trouve typiquement entre 250 et 300 nm sous la surface. Cette profondeur peut être ajustée en jouant sur les conditions d'implantation et plus particulièrement sur l'énergie d'implantation.

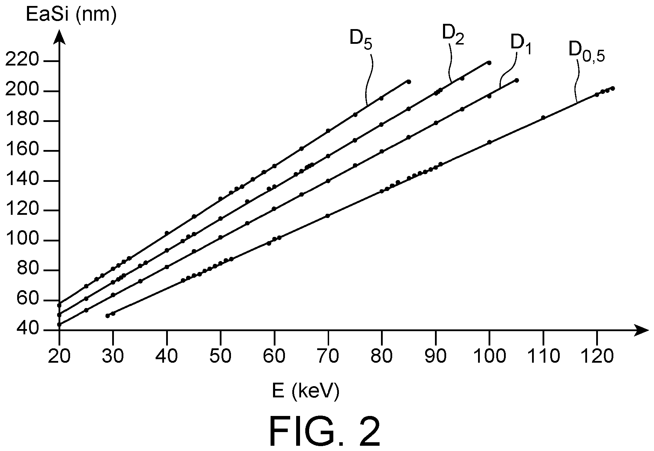

Dans une étape E3' facultative, le substrat donneur peut subir une étape d'amorphisation superficielle de la couche semi-conductrice, par exemple à l'aide d'une implantation ionique, pour former une zone amorphe superficielle. Cette implantation peut être à base notamment d'une ou plusieurs des espèces suivantes : silicium, germanium, phosphore, arsenic, azote ou argon avec une dose typiquement comprise entre 10¹⁴ et 10¹⁶ at/cm². La figure 2 représente l'épaisseur d'une zone de silicium EaSi rendue amorphe au moyen d'une implantation de silicium en fonction de l'énergie d'implantation E pour différentes doses d'implantation (D_{0,5} : 5.10¹⁴ at/cm²; D₁ : 10¹⁵ at/cm² ; D₂ : 2.10¹⁵ at/cm² ; D₅ : 5.10¹⁵ at/cm²).

Lors de cette étape E3', on prévoit de préférence que la zone amorphe reste à plus de 100 nm, voire à plus de 150 nm, du plan de fragilisation afin de ne pas gêner la propagation ultérieure de l'onde de fracture. Le matériau amorphe ayant une température de fusion inférieure, l'étape de guérison ultérieure va nécessiter un recuit à température plus faible. La création de cette zone amorphe peut également permettre de mieux contrôler cette guérison. Cette zone amorphe sera recristallisée lors du recuit de guérison décrit ci-dessous.

Pour assurer la guérison des défauts présents dans la couche semi-conductrice 3, l'invention propose comme indiqué précédemment de réaliser un recuit localisé du substrat donneur implanté. Ce recuit est mis en œuvre lors d'une étape E4 du procédé de transfert. Il en résulte une couche témoin guérie 20 et une portion avant 31 de la couche mince (comprenant l'éventuelle zone amorphe recristallisée) elle aussi guérie. Une portion arrière 32 de la couche mince au contact du plan de fragilisation 4 peut, du fait de la sélectivité en profondeur du recuit, ne pas être guérie.

Suite à la guérison, le procédé de transfert comprend le retrait de la couche témoin guérie lors d'une étape E5, et lors d'une étape E6 la mise en contact du substrat donneur avec un substrat receveur 5 pour former un ensemble à fracturer. Cette formation peut être réalisée par assemblage direct, par exemple par adhésion moléculaire. Puis, suite à la mise en contact, le procédé comprend lors d'une étape E7 une fracture de l'ensemble à fracturer le long du plan de fragilisation 4, ce qui conduit au détachement de la couche semi-conductrice 31, 32 du substrat donneur et à son transfert sur le substrat receveur. Cette fracture comprend un traitement thermique de fragilisation appliqué à l'ensemble à fracturer. Ce traitement thermique fournit l'énergie suffisante pour qu'une onde de fracture, une fois initiée, se propage de manière auto-entretenue. Dans une première variante, le traitement thermique de fragilisation est suffisant à lui seul pour initier l'onde de fracture. Dans une seconde variante, le procédé de transfert comprend un apport d'énergie additionnelle localisé, après ou pendant le traitement thermique de fragilisation, pour initier l'onde de fracture. Cette énergie peut être d'origine mécanique, thermique ou de toute autre origine. Il peut s'agir par exemple d'un chauffage localisé réalisé par un laser ou d'un apport d'énergie par ultrasons.

Un amincissement de la couche semi-conductrice peut ensuite être réalisé lors d'une étape E8 pour n'en conserver qu'une épaisseur utile correspondant au plus à la portion avant guérie 31.

Ainsi le procédé de transfert comprend, avant la mise en contact des substrats donneur et receveur, une guérison de défauts de la couche semi-conductrice liés à l'implantation d'espèces. Comme indiqué précédemment, cette guérison comprend un recuit localisé du substrat donneur provoquant un échauffement de la couche semi-conductrice 3 dont l'intensité est maximale en surface et décroit de la face avant Fa de la couche semi-conductrice 3 en direction du plan de fragilisation 4. Ce recuit sélectif en profondeur est réalisé en soumettant la surface avant du substrat donneur à une irradiation laser. L'irradiation laser peut être pratiquée à pression atmosphérique ou encore sous vide, de préférence sous atmosphère inerte ou sous atmosphère réductrice.

L'irradiation laser est de préférence une irradiation impulsionnelle dont les conditions opératoires sont choisies pour échauffer la portion avant 31 de la couche semi-conductrice sans provoquer un bullage du plan de fragilisation 4.

Notamment, la longueur d'onde de l'irradiation laser est de préférence choisie pour conduire à une forte absorption du rayonnement par le matériau du substrat donneur. De telle manière, l'essentiel du rayonnement envoyé sur le substrat donneur implanté peut être absorbé dans les premiers nanomètres, typiquement par les premiers 50 nm de matériau. On choisit par exemple un laser de longueur d'onde inférieure à 400 nm dans le cas où le substrat donneur est en silicium, en germanium ou en silicium-germanium.

La durée d'une impulsion laser est quant à elle choisie suffisamment courte pour que la chaleur déposée dans les premiers nanomètres n'ait pas le temps de diffuser significativement en profondeur jusqu'au plan de fragilisation 4 sous peine de provoquer le bullage. Par exemple, dans le cas d'un substrat donneur présentant un plan de fragilisation localisé en profondeur entre 150 et 1500 nm de la face avant de la couche semi-conductrice, la durée d'impulsion est choisie sous la microseconde, typiquement entre 20 et 200ns.

D'autres conditions opératoires de l'irradiation laser pouvant être contrôlées sont la densité surfacique d'énergie et le nombre d'impulsions irradiant une même région de surface. Ces autres conditions sont choisies de sorte à atteindre une température suffisante pour que la portion avant guérie 31 de la couche semi-conductrice présente une épaisseur au moins égale à l'épaisseur utile de la couche semi-conductrice dans le composant final. Par exemple, on peut être amené à transférer une couche semi-conductrice d'épaisseur 250nm pour *in fine* n'en conserver que les derniers nanomètres (5 à 30 nm pour une couche utile très fine, ou encore 50 à 150nm pour une couche utile plus épaisse). Le recuit laser vient ainsi guérir le cristal sur cette épaisseur utile de la couche semi-conductrice. Pour un substrat donneur en silicium, la densité d'énergie est alors choisie pour dépasser 1000°C, plus favorablement 1200°C, dans toute l'épaisseur utile.

Deux régimes de recuit laser peuvent être distingués: un régime sous la fusion et un régime dépassant la fusion. Selon le régime sous la fusion, la guérison est assurée par un recuit laser qui comprend une ou plusieurs impulsions ayant chacune une densité d'énergie choisie pour ne pas entraîner la fusion de la surface irradiée. Selon le régime dépassant la fusion, la guérison est assurée par un recuit laser qui peut ne comprendre qu'une impulsion ayant une densité d'énergie plus importante choisie pour entraîner la fusion de la surface irradiée. Dans le cadre de ce régime dépassant la fusion, le substrat peut être recouvert (par dépôt ou croissance épitaxiale) d'une couche témoin 2 réalisée en un matériau qui présente une température de fusion plus basse que celle du matériau de la couche semi-conductrice (par exemple une couche témoin de SiGe pour un substrat donneur en Si). Le recuit laser vient alors faire fondre uniquement la couche témoin et pas la couche semi-conductrice sous-jacente. La fusion de la couche témoin peut être détectée en temps réel durant le recuit laser en mesurant l'évolution de la réflectivité de l'empilement par réflectométrie TRR (« Time Resolved Reflectometry »). De cette façon, il est possible d'avoir une idée de la température atteinte en surface du substrat donneur durant le recuit laser. La couche témoin peut le cas échéant être ensuite retirée par exemple par gravure sélective, en particulier si sa rugosité de surface n'est pas compatible avec le collage ultérieur.

Dans un mode de réalisation possible, la température du substrat donneur est élevée avant et pendant le recuit laser au moyen d'un élément chauffant configuré pour réaliser un chauffage de l'intégralité du substrat donneur à une température choisie pour ne pas provoquer un bullage du plan de fragilisation, par exemple à une température comprise entre 50°C et 450°C.

L'invention permet au moyen d'un recuit laser suffisamment court (inférieur à la microseconde) et avec une longueur d'onde convenablement sélectionnée (inférieure à 600 nm) de limiter l'échauffement à la surface et à un volume très proche de la surface du substrat donneur. Ceci permet de chauffer préférentiellement la zone endommagée traversée par l'implantation ionique sur une profondeur dépendante de la longueur d'onde et de la durée de l'impulsion laser. Ce procédé permet de monter à de très hautes températures (même jusqu'à la fusion du matériau de la couche semi-conductrice) dans la portion avant 31 de la couche semi-conductrice, tout en confinant cet échauffement pour ne pas provoquer de bullage du plan de fragilisation 4. Ces hautes températures, en plus de permettre la guérison des défauts liés à l'implantation et ainsi de retrouver les propriétés électriques initiales du matériau semi-conducteur, peuvent en outre permettre l'activation de dopants ou d'autres traitements thermiques à haute température qui ne peuvent pas être utilisés sur des substrats susceptibles d'être endommagés. En effet, de par l'utilisation du recuit laser avant même le collage, il est possible de s'affranchir des contraintes liées aux limitations de budget thermique, comme la nécessité d'avoir une couche thermiquement isolante par exemple.

Dans un mode de réalisation possible, le recuit laser peut venir irradier une surface de taille variable entre quelques mm² et quelques cm². La forme et la taille de cette surface peut être contrôlée au moyen de masques. Une partie du substrat plutôt qu'une autre est ainsi préférentiellement soumise au recuit ce qui permet de réaliser une guérison localisée de la couche mince.

### Premier exemple de réalisation de l'invention

Ce premier exemple concerne le transfert d'une couche mince de silicium monocristallin et d'une couche d'isolant en SiO₂ sur un substrat receveur comportant des composants électroniques partiellement ou totalement élaborés et intégrant de ce fait des couches sensibles à la température, notamment des lignes de cuivre enterrées. La présence de ces couches sensibles rend impraticable l'application au substrat receveur d'un traitement thermique dépassant 400°C.

Après implantation ionique du substrat donneur par de l'hydrogène, ce substrat est irradié avec un laser pulsé de longueur d'onde ultraviolet (350 à 450nm), de durée d'impulsion inférieure à 200ns et avec un faisceau rectangulaire de taille proche de 26 x 36 mm². Toute la surface du substrat donneur est irradiée en utilisant environ 260 tirs laser. Ces tirs présentent un recouvrement d'environ 500µm afin d'assurer un traitement uniforme de toute le surface du substrat. La puissance du laser est choisie de façon à faire fondre une partie de la couche à transférer tout en évitant de faire buller le plan de fragilisation. La densité surfacique d'énergie est choisie de sorte à guérir le cristal du substrat donneur entre sa surface avant et une profondeur voisine de 100nm. Après ce traitement par laser, il est possible de réaliser une étape de polissage mécano-chimique du substrat donneur afin d'en réduire la rugosité de surface et de permettre son collage avec le substrat receveur. Une fois les substrats donneur et receveur collés, ils sont soumis à un traitement thermique de fragilisation à 400°C afin de déclencher la fracture et permettre le transfert de la couche de silicium dont une épaisseur est déjà guérie. La couche transférée peut ensuite être amincie par gravure chimique ou par polissage mécano-chimique pour atteindre une épaisseur utile au plus égale à celle guérie par le recuit. La couche mince amincie à 100nm ou moins ne comporte plus de défauts et présente des performances électriques équivalentes à celle d'une couche non implantée et parfaitement cristalline. De nouveaux composants peuvent être fabriqués sur la couche transférée amincie, permettant une intégration dite 3D.

### Second exemple de réalisation de l'invention

Dans ce second exemple, le substrat donneur est un substrat de silicium monocristallin recouvert par épitaxie d'une couche de Si_{0.90}Ge_{0.10} de 10nm d'épaisseur. Le substrat donneur est soumis à une implantation ionique d'hélium puis d'hydrogène. Sans que cela ne soit exclusif de cet exemple, le recuit de guérison est pratiqué préférentiellement après ces deux d'implantation mais peut aussi être pratiqué en deux étapes après chacune des implantations. Dans cet exemple, le recuit de guérison est ajusté de sorte à conduire à la fusion temporaire de la couche de SiGe (qui présente un point de fusion plus bas que celui du silicium) mais pas du silicium sous-jacent. La guérison du silicium a donc lieu en phase solide, jusqu'à une profondeur voisine de 50nm. Plusieurs impulsions laser sont appliquées en chaque point du substrat donneur. La couche mince de SiGe est ensuite retirée par gravure sélective par rapport au silicium, de sorte à retrouver la surface lisse initiale du substrat donneur avant épitaxie. Si besoin, une étape de polissage mécano-chimique peut être réalisé à ce stade pour préparer la surface au collage ultérieur. Le substrat donneur est ensuite collé sur un substrat receveur identique au premier exemple ou encore sur un substrat receveur en verre qui présente un point de fusion bien inférieur à la température, généralement de plus de 600°C, utilisée par les traitements thermiques de guérison classiques. Le substrat receveur en verre est préférentiellement recouvert d'un film mince de SiO2 et soumis à un polissage mécano-chimique en vue du collage. Après un recuit de fracture à 500°C, la couche de silicium transférée est amincie par polissage mécano-chimique jusqu'à atteindre une épaisseur de 30nm. Une couche de silicium sur verre SOG (« Silicon On Glass ») est ainsi obtenue dont les propriétés électriques ont été restaurées sur toute son épaisseur.

### Troisième exemple de réalisation de l'invention

Ce troisième exemple est une variante du premier exemple.

L'implantation ionique du substrat donneur par de l'hydrogène est réalisée pour créer un plan de fragilisation à 500 nm de profondeur. Après cette implantation, le substrat donneur est amorphisé sur 100 nm d'épaisseur depuis sa surface par implantation de silicium (avec une dose de 10¹⁵ at/cm² et une énergie de 50 KeV). Ce substrat est ensuite irradié avec un laser pulsé dans des conditions proches de l'exemple 1 mais ces conditions sont adaptées pour permettre également d'atteindre sur l'épaisseur de la couche amorphisée le point de fusion du matériau amorphe permettant ainsi sa recristallisation. La suite du procédé est similaire au premier exemple.

## Revendications

1. Procédé de guérison de défauts générés dans une couche semi-conductrice (3) par une implantation d'espèces réalisée dans un substrat (1) pour y former un plan de fragilisation (4) séparant une partie massive du substrat (10) de la couche semi-conductrice (3), la couche semi-conductrice (3) ayant une face avant traversée par les espèces implantées, **caractérisé en ce qu'**il comporte un recuit localisé comprenant une irradiation laser d'une surface avant du substrat provoquant un échauffement de la couche semi-conductrice dont l'intensité décroit de la face avant en direction du plan de fragilisation.

2. Procédé selon la revendication 1, dans lequel l'irradiation laser est une irradiation impulsionnelle dont les conditions opératoires sont choisies pour échauffer une portion avant (31) de la couche semi-conductrice sans provoquer un bullage du plan de fragilisation.

3. Procédé selon la revendication 2, dans lequel le substrat est en silicium, en germanium ou en silicium-germanium et l'irradiation laser présente une longueur d'onde inférieure à 400 nm.

4. Procédé selon la revendication 2, dans lequel la durée de la ou des impulsions de l'irradiation laser est inférieure à une microseconde, de préférence comprise entre 20 et 200 nanosecondes.

5. Procédé selon la revendication 2, dans lequel la ou les impulsions de l'irradiation laser présentent une densité surfacique d'énergie choisie pour échauffer la portion avant de la couche semi-conductrice à une température supérieure à 1000°C, de préférence supérieure à 1200°C.

6. Procédé selon la revendication 5, dans lequel l'irradiation laser comprend une ou plusieurs impulsions ayant chacune une densité d'énergie choisie pour ne pas entraîner la fusion de la surface avant.

7. Procédé selon la revendication 5, dans lequel l'irradiation laser comprend une seule impulsion dont la densité d'énergie est choisie pour entraîner la fusion de la surface avant.

8. Procédé selon la revendication 7, dans lequel la couche semi-conductrice est recouverte d'une couche témoin (2) qui présente une température de fusion inférieure à la température de fusion de la couche semi-conductrice.

9. Procédé selon l'une des revendications 1 à 8, comprenant avant le recuit localisé une amorphisation superficielle de la couche semi-conductrice.

10. Procédé selon l'une des revendications 1 à 9, comprenant en outre un chauffage de l'intégralité du substrat à une température choisie pour ne pas provoquer un bullage du plan de fragilisation, par exemple à une température comprise entre 50°C et 450°C.

11. Procédé de transfert d'un substrat donneur (1) vers un substrat receveur (5) d'une couche semi-conductrice (3) ayant une face avant (Fa), le substrat donneur comportant un plan de fragilisation (4) formé par implantation d'espèces qui sépare la couche semi-conductrice d'une partie massive (10) du substrat donneur, le procédé comprenant les étapes de :
- mise en contact du substrat donneur et du substrat receveur pour former un ensemble à fracturer ;
- fracture de l'ensemble à fracturer le long du plan de fragilisation de manière à transférer la couche semi-conductrice sur le substrat receveur ;
**caractérisé en ce qu'**il comprend avant la mise en contact une guérison de défauts de la couche semi-conductrice liés à l'implantation d'espèces à travers la face avant, ladite guérison comportant un recuit localisé comprenant une irradiation laser d'une surface avant du substrat donneur provoquant un échauffement de la couche semi-conductrice dont l'intensité décroit de la face avant en direction du plan de fragilisation.

12. Procédé selon la revendication 11, dans lequel la fracture comprend un traitement thermique de fragilisation appliqué à l'ensemble à fracturer qui échauffe le plan de fragilisation à une température supérieure à celle à laquelle il est échauffé par le recuit localisé.

13. Procédé selon l'une des revendications 11 et 12, comprenant en outre un amincissement de la couche semi-conductrice transférée sur le substrat receveur.

## Patentansprüche

1. Verfahren zur Ausheilung von in einer halbleitenden Schicht (3) erzeugten Defekten, durch eine in einem Substrat (1) ausgeführte Spezies-Implantation, um darin eine Versprödungsebene (4) zu bilden, die einen massiven Bereich des Substrats (10) von der halbleitenden Schicht (3) trennt, wobei die halbleitende Schicht (3) eine von den implantierten Spezies durchquerte Vorderfläche hat, **dadurch gekennzeichnet, dass** es ein lokalisiertes Glühen beinhaltet, das eine Laserbestrahlung einer vorderen Oberfläche des Substrats umfasst, die eine Erwärmung der halbleitenden Schicht verursacht, deren Intensität von der Vorderfläche in Richtung der Versprödungsebene abnimmt.

2. Verfahren nach Anspruch 1, wobei die Laserbestrahlung eine Impulsbestrahlung ist, deren Betriebsbedingungen gewählt werden, um einen vorderen Abschnitt (31) der halbleitenden Schicht zu erwärmen, ohne eine Blasenbildung der Versprödungsebene zu verursachen.

3. Verfahren nach Anspruch 2, wobei das Substrat aus Silizium, Germanium oder Siliziumgermanium besteht und die Laserbestrahlung eine Wellenlänge von weniger als 400 nm aufweist.

4. Verfahren nach Anspruch 2, wobei die Dauer des oder der Impulse der Laserbestrahlung weniger als eine Mikrosekunde beträgt, vorzugsweise zwischen 20 und 200 Nanosekunden.

5. Verfahren nach Anspruch 2, wobei der oder die Impulse der Laserbestrahlung eine Oberflächenenergiedichte aufweisen, die gewählt wird, um den vorderen Abschnitt der halbleitenden Schicht auf eine Temperatur von mehr als 1000 °C, vorzugsweise höher als 1200 °C zu erwärmen.

6. Verfahren nach Anspruch 5, wobei die Laserbestrahlung einen oder mehrere Impulse umfasst, die jeweils eine Energiedichte haben, die gewählt wird, um nicht das Schmelzen der vorderen Oberfläche herbeizuführen.

7. Verfahren nach Anspruch 5, wobei die Laserbestrahlung einen einzelnen Impuls umfasst, dessen Energiedichte gewählt wird, um das Schmelzen der vorderen Oberfläche herbeizuführen.

8. Verfahren nach Anspruch 7, wobei die halbleitende Schicht mit einer Kontrollschicht (2) überzogen ist, die eine tiefere Schmelztemperatur als die Schmelztemperatur der halbleitenden Schicht aufweist.

9. Verfahren nach einem der Ansprüche 1 bis 8, vor dem lokalisierten Glühen eine oberflächliche Amorphisierung der halbleitenden Schicht umfassend.

10. Verfahren nach einem der Ansprüche 1 bis 9, ferner ein Erhitzen des gesamten Substrats auf eine Temperatur umfassend, die gewählt wird, um nicht eine Blasenbildung der Versprödungsebene zu verursachen, beispielsweise auf eine Temperatur zwischen 50 °C und 450 °C.

11. Verfahren zum Übertragen eines Donatorsubstrats (1) auf ein Empfängersubstrat (5) einer halbleitenden Schicht (3), die eine Vorderfläche (Fa) hat, wobei das Donatorsubstrat eine Versprödungsebene (4) aufweist, die durch Spezies-Implantation gebildet wird, die die halbleitende Schicht von einem massiven Bereich (10) des Donatorsubstrats trennt, wobei das Verfahren die Schritte umfasst:
- Inkontaktbringen des Donatorsubstrats mit dem Empfängersubstrat, um eine Einheit zum Brechen zu bilden;
- Brechen der Einheit zum Brechen entlang der Versprödungsebene, um die halbleitende Schicht auf das Empfängersubstrat zu übertragen;
**dadurch gekennzeichnet, dass** es vor dem Inkontaktbringen eine Ausheilung der Defekte der halbleitenden Schicht umfasst, die mit der Spezies-Implantation durch die Vorderfläche verbunden ist, wobei die Ausheilung ein lokalisiertes Glühen beinhaltet, das eine Laserbestrahlung einer vorderen Oberfläche des Donatorsubstrats umfasst, die eine Erwärmung der halbleitenden Schicht verursacht, deren Intensität von der Vorderfläche in Richtung der Versprödungsebene abnimmt.

12. Verfahren nach Anspruch 11, wobei der Bruch eine Bearbeitung thermischer Versprödung umfasst, die auf die Einheit zum Brechen angewendet wird, die die Versprödungsebene auf eine Temperatur erwärmt, die höher ist als jene, auf die sie durch das lokalisierte Glühen erwärmt wird.

13. Verfahren nach einem der Ansprüche 11 und 12, ferner eine Ausdünnung der auf das Empfängersubstrat übertragenen halbleitenden Schicht umfassend.

## Claims

1. A method of healing defects generated in a semiconducting layer (3) by an implantation of species made in a substrate (1) to form therein an embrittlement plane (4) separating a solid part of the substrate (10) from the semiconducting layer (3), the semiconducting layer (3) having a front face through which the implanted species pass, **characterized in that** it comprises a local annealing comprising a laser irradiation of a front surface of the substrate generating a heating of the semiconducting layer with an intensity that decreases from the front face towards the embrittlement plane.

2. The method according to claim 1, wherein the laser irradiation is a pulse irradiation for which the operating conditions are chosen to heat a front portion (31) of the semiconducting layer without causing the formation of bubbles in the embrittlement plane.

3. The method according to claim 2, wherein the substrate is made of silicon, germanium or silicon-germanium and the laser irradiation has a wavelength of less than 400 nm.

4. The method according to claim 2, wherein the duration of the laser irradiation pulse(s) is less than one microsecond, preferably between 20 and 200 nanoseconds.

5. The method according to claim 2, wherein the laser irradiation pulse(s) have a surface energy density chosen to heat the front portion of the semiconducting layer to a temperature of more than 1000°C, and preferably more than 1200°C.

6. The method according to claim 5, wherein the laser irradiation comprises one or several pulses, each having an energy density chosen to not cause fusion of the front surface.

7. The method according to claim 5, wherein the laser irradiation comprises a single pulse which has an energy density chosen to cause fusion of the front surface.

8. The method according to claim 7, wherein the semiconducting layer is covered by a control layer (2) that has a melting temperature below a melting temperature of the semiconducting layer.

9. The method according to one of claims 1 to 8, further comprising a surface amorphisation of the semiconducting layer before the local annealing.

10. The method according to one of claims 1 to 9, also comprising heating the whole substrate to a temperature chosen to not cause the formation of bubbles in the embrittlement plane, for example at a temperature between 50°C and 450°C.

11. A method of transferring from a donor substrate (1) to a receiving substrate (5) a semiconducting layer (3) having a front face (Fa), the donor substrate comprising an embrittlement plane (4) formed by implantation of species that separates the semiconducting layer from a solid part (10) of the donor substrate, the method comprising the steps of:
- contacting the donor substrate and the receiving substrate to form an assembly to be fractured;
- fracturing the assembly to be fractured along the embrittlement plane so as to transfer the semiconducting layer onto the receiving substrate;
wherein the method further comprises, before the contacting, a step of healing defects generated in the semiconducting layer by the implantation of species through the front face, said healing including locally annealing comprising a laser irradiation of a front surface of the donor substrate to cause heating of the semiconducting layer with an intensity that decreases from the front face towards the embrittlement plane.

12. The method according to claim 11, wherein the fracturing includes a weakening heat treatment applied to the assembly to be fractured that heats the embrittlement plane to a temperature higher than a temperature to which it is heated by the local annealing.

13. The method according to claim 11 or 12, also comprising a step of thinning the semiconducting layer transferred onto the receiving substrate.
